# EUROPEAN PATENT SPECIFICATION

(11) **EP 3 370 253 B1**
(45) Date of publication and mention of the grant of the patent: **27.10.2021**
(21) Application number: 18158468.1
(22) Date of filing: 23.02.2018
(51) Int. Cl.: H01L 21/78

(54) **SEMICONDUCTOR WAFER DICING CRACK PREVENTION USING CHIP PERIPHERAL TRENCHES**
HALBLEITERWAFER-TRENNUNGSRISSVERHINDERUNG UNTER VERWENDUNG VON PERIPHEREN CHIP-GRÄBEN
PRÉVENTION DES FISSURES LORS DE LA DÉCOUPE D'UNE TRANCHE DE SEMI-CONDUCTEUR AU MOYEN DE TRANCHÉES PÉRIPHÉRIQUES AUTOUR DES PUCES

(30) Priority: 28.02.2017 US 201715444386
(43) Date of publication of application: 05.09.2018
(73) Proprietor: Infineon Technologies Austria AG, 9500 Villach (AT)
(72) Inventor: POZZOVIVO, Gianmauro, 9520 Sattendorf (AT); ZECHMANN, Arno, 9500 Villach (AT)
(74) Representative: Moore, Derek

(56) References cited:
- EP-A2- 1 973 174
- US-A1- 2002 197 841
- US-A1- 2005 118 790
- US-A1- 2007 210 327
- LEI WEI-SHENG ET AL: "Die singulation technologies for advanced packaging: A critical review", JOURNAL OF VACUUM SCIENCE & TECHNOLOGY B: MICROELECTRONICS AND NANOMETER STRUCTURES, AMERICAN INSTITUTE OF PHYSICS, 2 HUNTINGTON QUADRANGLE, MELVILLE, NY 11747, vol. 30, no. 4, 6 April 2012 (2012-04-06), pages 40801-40801, XP012162844, ISSN: 2166-2746, DOI: 10.1116/1.3700230 [retrieved on 2012-04-06]

## Description

### TECHNICAL FIELD

The present application relates to semiconductor device fabrication, and in particular relates to wafer dicing.

### BACKGROUND

Semiconductor transistors, in particular field-effect controlled switching devices such as a MISFET (Metal Insulator Semiconductor Field Effect Transistor), in the following also referred to as MOSFET (Metal Oxide Semiconductor Field Effect Transistor) and a HEMT (high-electron-mobility Field Effect Transistor) also known as heterostructure FET (HFET) and modulation-doped FET (MODFET) are used in a variety of applications. HEMTs are preferred in many applications due to their favorable power density, on-state resistance, switching frequency, and efficiency benefits over conventional silicon based transistors. HEMTs are typically formed using type III-V semiconductor materials, such as GaN, GaAs, InGaN, AIGaN, etc.

One common technique for HEMT device formation involves an epitaxy process. According to this technique, a bulk wafer is provided. Typically, the bulk wafer includes a readily available semiconductor material, such as silicon or silicon carbide. Type III-V semiconductor material is then grown on a growth surface of the wafer using an epitaxial growth technique. The growth surface of the wafer can be aligned with the <111> crystallographic plane of the wafer crystal so as to provide a hexagonal lattice surface for the epitaxial growth of the type III-V semiconductor material thereon. Once the type III-V material is epitaxially grown, device formation (e.g., gate structuring, contact formation, etc.) is performed in the type III-V semiconductor layer. After completion of the front-end-of-the-line and back-end-of-the-line processing, the wafers are singulated (i.e., cut) into a plurality of semiconductor dies.

One notable challenge in the fabrication of HEMT devices using the above described epitaxial growth processes relates to breaking and/or cracking of the substrate. Because the growth surface of the base substrate includes the <111> crystallographic plane, the base substrate is quite prone to cleavage. Thus, the application of moderate mechanical force to the base substrate, which may be the result of unavoidable processing steps, e.g., wafer handling, may cause the base substrate to partially or completely break.

Another notable challenge in the fabrication of HEMT devices using the above described epitaxial growth processes relates to chipping and breakage of the type III-V semiconductor during die singulation process. Known die singulation techniques include mechanical or laser dicing. Typically, a mechanical scribe line is used to define the chip areas on the wafer. Subsequently, mechanical sawing or a laser cutting is performed along the mechanical scribe line to separate the wafer into individual dies. However, due to the above described issues related to the mechanical strength of the wafer, there is a substantial risk of chip breakage during the cutting process. Moreover, the sawing process can cause cracks to propagate across the type III-V semiconductor layer, which can lead to device failure. Approaches to remove type III-V semiconductor material by separate etching steps prior to mechanical dicing are very complex and costly and may also lead to increase of particle contamination on the device. The type III-V semiconductor material can also be removed by laser processes prior to mechanical sawing, but this process can lead to a decrease in chip breakage strength.

US 2005/118790 A1 discloses a method for dicing a wafer having a base material with a diamond structure. The wafer first undergoes a polishing process, in which a predetermined portion of the wafer is polished away from its back side. The wafer is then diced through at least one line along a direction at a predetermined offset angle from a natural cleavage direction of the diamond structure.

US2007/210327 A1 discloses a method of fabricating a light emitting device having an AlGaInP light emitting section, less causative of crack by cleavage on the edge portions on the back surface of the device chip in process of dicing or breaking. A light emitting device wafer is diced along a dicing line inclined at an angle of 15 DEG to 30 DEG , both ends inclusive, away from a dicing line angle reference direction defined as the <110> direction on the (100) main surface.

US2002197841 discloses a method of fabricating a III-V device on a (111) silicon substrate, wherein the periphery of the III-V region is aligned to the preferred cleavage planes.

### SUMMARY

Those skilled in the art will recognize additional features and advantages upon reading the following detailed description, and upon viewing the accompanying drawings.

In an embodiment, a method of forming a semiconductor device comprises providing a silicon base substrate comprising a substantially planar growth surface and one or more preferred crystallographic cleavage planes and an epitaxial type III-V semiconductor layer on the planar growth surface. The growth surface has a (111) plane and the preferred cleavage planes are the {110}, {011} and {101} crystallographic planes of the silicon base substrate. The type III-V semiconductor layer comprises a heterojunction, in which a GaN region and an AIGaN region, which have different bandgaps, adjoin one another so as to form a two-dimensional carrier gas. A mask is formed on an upper surface of the type III-V semiconductor layer with openings that expose the upper surface of the type III-V semiconductor layer and a first trench is formed by an etching process and semiconductor material that is exposed from the openings of the mask from the type III-V semiconductor layer is removed. The first trench vertically extends from an upper surface of the type III-V semiconductor layer at least to the planar growth surface. The first trench has a first trench length direction that is antiparallel to the one or more preferred crystallographic cleavage planes.

In some embodiments, the first trench extends into the planar growth surface such that an indentation in the planar growth surface of the semiconductor base substrate forms the base of the first trench.

The method may further comprise forming at least one second trench that vertically extends from an upper surface of the type III-V semiconductor layer at least to the planar growth surface, the second trench extending perpendicularly to the first trench and having a second trench length direction that is antiparallel to the one or more preferred crystallographic cleavage planes.

In some embodiments, the method further comprises forming device structures in component positions of the type III-V semiconductor layer, the component positions being arranged in a grid of rows and columns, each having a direction, wherein the direction is antiparallel with the one or more of the crystallographic cleavage planes.

The method may further comprise forming a cut that separates the type III-V semiconductor layer and the base substrate into two discrete semiconductor chips. In some embodiments, the cut is formed along a first cutting plane that is antiparallel to the one or more preferred crystallographic cleavage planes of the substrate.

In some embodiments, the base substrate comprises an indicator feature that indicates a crystallographic orientation of the substrate. The method may further comprise using the indicator feature to orient the first trench such that the first trench length direction extends along the plane that is antiparallel to the one or more preferred crystallographic cleavage planes of the substrate.

In some embodiments, the semiconductor base substrate comprises an indicator feature that identifies the preferred cleavage planes of the base substrate and the method further comprises positioning the indicator feature such that the preferred cleavage planes of the substrate are antiparallel and antiperpendicular to the indicator feature.

In some embodiments, the semiconductor base substrate comprises silicon and has a growth surface having a (111) plane and the indicator feature is positioned such that the {110}, {011} and {101}. crystallographic planes of the substrate are antiparallel and antiperpendicular to the indicator feature.

The indicator feature may be a flat edge. The semiconductor substrate may have a substantially circular contour and have the form of a disk. The flat edge may form a tangent to the circular contour and be formed by removing a portion of the circular outer contour. In some embodiments the method further comprises forming the first trench such that it is parallel or perpendicular to the flat edge.

In some embodiments, the method further comprises forming two first trenches extending parallel to one another along a first trench length direction, the first length direction being antiparallel to the one or more preferred crystallographic cleavage planes of the substrate and forming two second trenches extending parallel to one another along a second trench length direction that is perpendicular to the first trench length direction and antiparallel to the one or more preferred crystallographic cleavage planes of the substrate.

The type III-V semiconductor layer and the substrate may be cut along a first cutting plane that is parallel to the first trench length direction and between the two first trenches.

In some embodiments, the first trench and second trench if present are filled with a filler material that is different from material of the type III-V semiconductor layer. The filler material may comprise any one or combination of: a semiconductor oxide, a polycrystalline material, and a metal.

In an embodiment, a semiconductor chip comprises a semiconductor base substrate comprising a planar growth surface having a crystallographic direction, the semiconductor base substrate comprising preferred crystallographic cleavage planes, a type III-V semiconductor layer epitaxially formed on the planar growth surface and at least one trench is formed in the type III-V semiconductor layer that extends at least to the growth surface of the semiconductor base substrate. The at least one trench has a trench length direction that is antiparallel to the preferred crystallographic cleavage planes.

In this embodiment, the semiconductor base substrate of the semiconductor chip is a silicon wafer, the crystallographic direction of the planar growth surface is <111> and the preferred cleavage planes are {110}, {011} and {101}. In this embodiment, the type III-V semiconductor layer comprises a heterojunction, in which a GaN region and an AIGaN region, which have different bandgaps, adjoin one another so as to form a two-dimensional carrier gas.

In an embodiment, a silicon wafer comprises a planar growth surface having a (111) plane, and a flat edge. The flat edge that is antiparallel and antiperpendicular to {110}, {011} and {101}.crystallographic planes of the silicon wafer. The semiconductor wafer may have a substantially circular contour and have the form of a disk. The flat edge may form a tangent to the circular contour and be formed by removing a portion of the circular outer contour.

A method of forming a semiconductor device is disclosed. According to an embodiment of the method, a semiconductor base substrate having a substantially planar growth surface is provided. A type III-V semiconductor layer is epitaxially grown on the growth surface. First and second trenches that vertically extend from an upper surface of the type III-V semiconductor layer at least to the growth surface are formed. The first and second trenches are filled with a filler material that is different from material of the type III-V semiconductor layer. A cut that separates the type III-V semiconductor layer and the base substrate into two discrete semiconductor chips is formed. The cut is formed in a lateral section of the type III-V semiconductor layer that is between the first and second trenches.

In some embodiments, the first and second trenches are formed to define first, second and third lateral sections of the first layer, the first lateral section being disposed on one side of the first trench, the second lateral section being disposed between the first and second trenches, and the third lateral section being disposed on one side of the second trench, and wherein the cut is formed in the second lateral section.

In some embodiments, forming the cut causes a crack to propagate in the second lateral section, the crack extending away from the cut and reaching the first trench, and wherein the filler material prevents the crack from propagating into the second lateral section.

In some embodiments, forming the cut comprises a mechanical sawing process.

In some embodiments, the first and second trenches are formed to extend parallel to one another along a first trench length direction, and wherein forming the cut comprises cutting the type III-V semiconductor layer and the substrate along a first cutting plane that is parallel to the first trench length direction.

In some embodiments, cutting the type III-V semiconductor layer and the substrate along the first cutting plane comprises cutting the substrate along a plane that is antiparallel to a crystallographic cleavage plane of the substrate.

In some embodiments, the base substrate comprises an indicator feature that indicates a crystallographic orientation of the substrate, the method further comprising: using the indicator feature to orient the substrate prior to formation of the first and second trenches such that the first trench length direction extends along the plane that is antiparallel to a crystallographic cleavage plane of the substrate.

In some embodiments, the indicator feature is used to determine the <101 >, the <110>, and the <011> crystallographic planes of the base substrate, the method further comprising using the indicator feature to rotate the substrate prior to forming the first and second trenches such that the <101>, the <110>, and the <011 > crystallographic planes of the substrate are antiparallel and anti-perpendicular to the first trench length direction of the first and second trenches.

In some embodiments, the method further comprises forming third and fourth trenches that vertically extend from an upper surface of the type III-V semiconductor layer at least to the growth surface, the third and fourth trenches extending parallel to one another along a second trench length direction that is perpendicular to the first trench length direction; and using the indicator feature to orient the substrate prior to formation of the first, second, third, and fourth trenches such that the first and second trench length directions extend along planes that are antiparallel to a crystallographic cleavage plane of the substrate.

The filler material may comprise a polycrystalline semiconductor material, or an oxide material.

In some embodiments, the method further comprises forming one or more semiconductor devices in the first lateral section prior to forming the cut.

In some embodiments, filling the first and second trenches with a filler material comprises forming a diode in the first and second trenches, the method further comprising connecting the diode to output terminals one of the semiconductor devices.

According to another embodiment of the method, a wafer having a base substrate and a type III-V semiconductor layer being formed on a growth surface of the base substrate is proved. Sets of spaced apart trenches are formed in the wafer. The sets of spaced apart trenches intersect with one another and enclose first lateral sections of the type III-V semiconductor layer. Each of the sets of spaced apart trenches include first and second trenches that vertically extend from an upper surface of the type III-V semiconductor layer at least to the growth surface and laterally extend parallel to one another. The wafer is separated into a plurality of semiconductor chips by cutting second lateral sections of the type III-V semiconductor layer that are between the first and second trenches.

In some embodiments, the method further comprises filling the sets of spaced apart trenches with a crack propagation resistant material prior to separating the wafer. The crack propagation resistant material may comprise any one or combination of: a semiconductor oxide, a polycrystalline material, and a metal.

In some embodiments, the base substrate comprises an indicator feature that indicates a crystallographic plane of the substrate, the method further comprising using the indicator feature to orient the substrate prior to formation of the sets of spaced apart trenches such that the sets of spaced apart trenches laterally extend along a plane that is antiparallel to a crystallographic cleavage plane of the substrate.

A semiconductor chip is disclosed. According to an embodiment, the semiconductor chip includes a semiconductor base substrate having a planar growth surface. A type III-V semiconductor layer is formed on the growth surface. having a crystallographic direction and preferred crystallographic cleavage planes. The semiconductor base substrate is a silicon wafer, the crystallographic direction of the growth surface is <111> and the preferred cleavage planes are {110}, {011} and {101}. The type III-V semiconductor layer that is epitaxially formed on the planar growth surface comprises a heterojunction, in which a GaN region and an AIGaN region, which have different bandgaps, adjoin one another so as to form a two-dimensional carrier gas. At least one etched trench is formed in the type III-V semiconductor layer that extends at least to the growth surface of the semiconductor base substrate. The at least one trench has a trench length direction that is antiparallel to the preferred crystallographic cleavage planes.

In some embodiments, first, second, third and fourth trenches vertically extend from an upper surface of the type III-V semiconductor layer at least to the growth surface. A filler material that is different from material of the type III-V semiconductor layer fills the first, second, third and fourth trenches. A central lateral section of the type III-V semiconductor layer is enclosed by the first, second, third and fourth trenches. An outer lateral section of the type III-V semiconductor layer that extends to an edge side of the semiconductor chip is physically decoupled from the central lateral section.

In some embodiments, the first and second trenches vertically extend from the upper surface of the type III-V semiconductor layer to a location that is within the base substrate.

In some embodiments, the chip further comprises a crack in the outer lateral section of the first layer, the crack terminating at one of the first, second, third and fourth trenches.

As used herein the term "antiparallel" denotes a plane or direction that is non parallel and unaligned with a further plane or direction and, therefore, forms an inclined angle with the further plane or direction that is greater than 0° and less than 90°. As used herein the term "antiperpendicular" denotes a plane or direction that is non perpendicular with a further plane or direction and, therefore, forms an inclined angle with the further plane or direction that is greater than 0° and less than 90°.

### BRIEF DESCRIPTION OF THE FIGURES

The elements of the drawings are not necessarily to scale relative to each other. Like reference numerals designate corresponding similar parts. Embodiments are depicted in the drawings and are detailed in the description which follows.
Figure 1, which includes Fig. 1A and 1B, illustrates a semiconductor base substrate, according to an embodiment. Fig. 1A depicts the semiconductor base substrate from a plan view perspective and Fig. 1B depicts the semiconductor base substrate from a cross-sectional perspective.
Figure 2 depicts a type III-V semiconductor layer formed on the semiconductor base substrate from a cross-sectional perspective, according to an embodiment.
Figure 3 depicts a patterned lithography mask formed on the type III-V semiconductor layer from a cross-sectional perspective, according to an embodiment.
Figure 4 depicts the patterned lithography mask formed on the type III-V semiconductor layer from a plan view perspective, according to an embodiment.
Figure 5 depicts first and second trenches being formed in the type III-V semiconductor layer from a cross-sectional perspective, according to an embodiment.
Figure 6 depicts a hard mask and a patterned lithography mask formed on the type III-V semiconductor layer from a cross-sectional perspective, according to an embodiment.
Figure 7 depicts first and second trenches being formed in the type III-V semiconductor layer from a cross-sectional perspective, according to another embodiment.
Figure 8 depicts a filler material being formed in the first and second trenches from a cross-sectional perspective, according to an embodiment.
Figure 9 depicts planarization of the filler material and formation of semiconductor devices in the type III-V semiconductor layer, according to another embodiment.
Figure 10 depicts a sawing line between the first and second trenches, according to an embodiment.
Figure 11 depicts a plurality of semiconductor chips that are formed by the separation process and have cracks from the singulation process, according to an embodiment.
Figure 12, which includes Fig. 12A and 12B, illustrates a semiconductor base substrate and the crystallographic planes of a <111> semiconductor base substrate, according to an embodiment. Fig. 12A depicts the semiconductor base substrate from a plan view perspective and Fig. 12B depicts the semiconductor base substrate from a cross-sectional perspective.

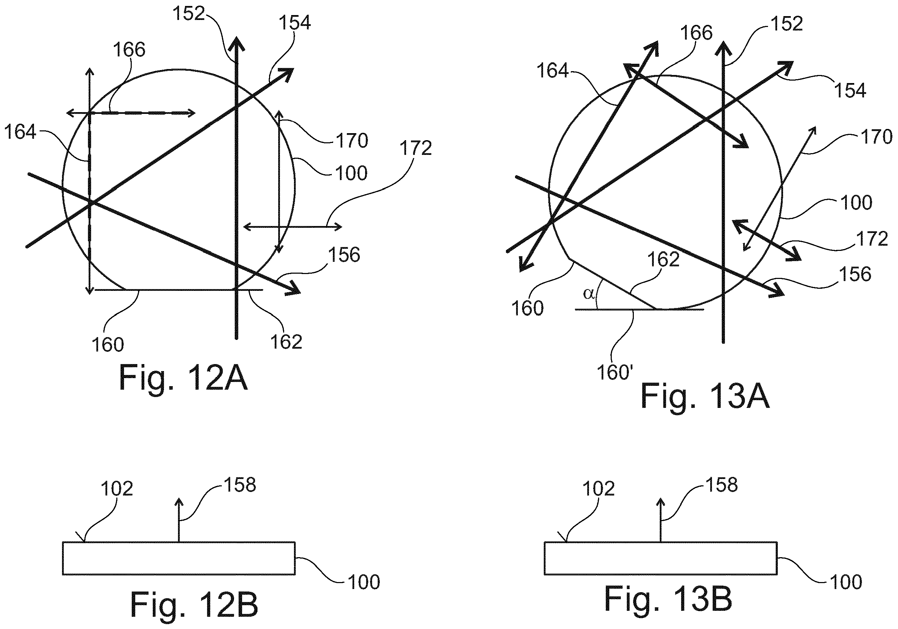

Figure 13, which includes Fig. 13A and 13B, illustrates the semiconductor base substrate being rotated such that the crystallographic planes of the <111> semiconductor base substrate are antiparallel and antiperpendicular to the trench length directions, according to an embodiment. Fig. 13A depicts the <111> semiconductor base substrate from a plan view perspective and Fig. 13B depicts the <111> semiconductor base substrate from a cross-sectional perspective. As used herein the term "antiparallel" denotes a plane or direction that is non parallel and unaligned with a further plane or direction and, therefore, forms an inclined angle with the further plane or direction that is greater than 0° and less than 90°. As used herein the term "antiperpendicular" denotes a plane or direction that is non perpendicular with a further plane or direction and, therefore, forms an inclined angle with the further plane or direction that is greater than 0° and less than 90°.
Figure 14, which includes Fig. 14A and 14B, illustrates the <111> semiconductor base substrate with a type III-V semiconductor layer being formed after rotation of the <111> semiconductor base substrate, according to an embodiment. Fig. 14A depicts the <111> semiconductor base substrate from a plan view perspective and Fig. 14B depicts the <111> semiconductor base substrate from a cross-sectional perspective.
Figure 15, which includes Fig. 15A and 15B, illustrates the <111> semiconductor base substrate with first and second trenches that are formed after rotation of the <111> semiconductor base substrate, according to an embodiment, according to an embodiment. Fig. 15A depicts the <111> semiconductor base substrate from a plan view perspective and Fig. 15B depicts the <111> semiconductor base substrate from a cross-sectional perspective.

### DETAILED DESCRIPTION

According to embodiments described herein, crack stopping trenches are used to prevent cracks from propagating into the active area of semiconductor dies during the die singulation process. The crack stopping trenches are formed in an type III-V semiconductor layer that is epitaxially grown on a base substrate. The crack prevention trenches are formed around the periphery of the die areas in the shape of a dicing pattern. Before formation of semiconductor devices in the die portions of the type III-V semiconductor layer, the crack stopping trenches are filled with a filler material that is different from the type III-V semiconductor material. After front-end-of-the-line and back-end-of-the-line processing is completed, a simple, low-cost mechanical sawing process is performed in the dicing region between two crack stopping trenches to singulate the wafer into individual semiconductor chips. This sawing process may induce cracks in the type III-V semiconductor layer.

Advantageously, the crack stopping trenches prevent any cracks that may arise in the type III-V semiconductor layer during the die singulation process from reaching the active devices in the semiconductor dies. The crack stopping trenches can advantageously implemented at low cost with minimal processing steps. Moreover, the crack stopping trenches enable a low cost die singulation technique with minimal preparatory steps (e.g., etching) without creating an unacceptably high defect rate due to cracking. According to certain advantageous embodiments, the trenches can additionally provide functionality in the completed semiconductor devices. For instance, the crack stopping trenches can be configured as diodes or electrical connectors that are electrically connected to the active semiconductor devices. In other embodiments, the crack stopping trenches can be configured as electrical isolation trenches.

According to one embodiment, a wafer orientation technique is performed prior to trench formation. This wafer orientation technique ensures that the crack stopping trenches are not aligned with a preferred cleavage plane of the base substrate and consequently improves the mechanical strength of the wafers. One example of this technique involves using a physical indicator feature on the base substrate to determine the <101 >, <110>, and <011> crystallographic planes. The base substrate is rotated prior to trench formation such that, when the crack stopping trenches are formed, the crack stopping trenches are not parallel or perpendicular to the preferred crystallographic cleavage planes of the substrate, i.e., the <101>, <110> and <011> planes. That is, the sidewalls of the crack stopping trenches extend in a length direction that is not parallel or perpendicular to the <101 >, <110> and <011> crystallographic planes of the substrate. As a result, the likelihood of substrate breakage along one of the preferred cleavage planes of the base substrate is substantially reduced. As used herein, the term "preferred crystallographic cleavage plane" denotes a crystallographic plane of the base substrate that is more likely to split upon application of a force than other crystallographic planes of the base substrate.

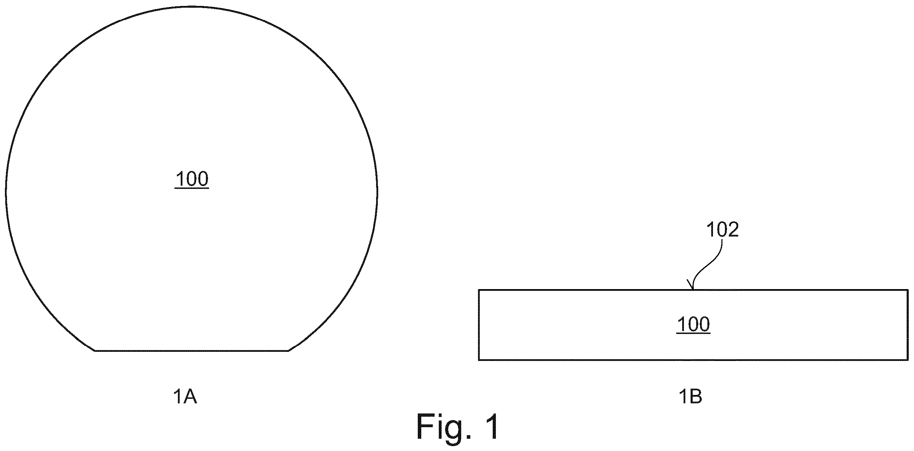

Referring to Fig. 1, a semiconductor base substrate 100 is depicted. According to the presently claimed invention, the base substrate 100 is a silicon bulk substrate with a substantially planar growth surface 102 that exposes the <111> crystallographic plane of the silicon material.

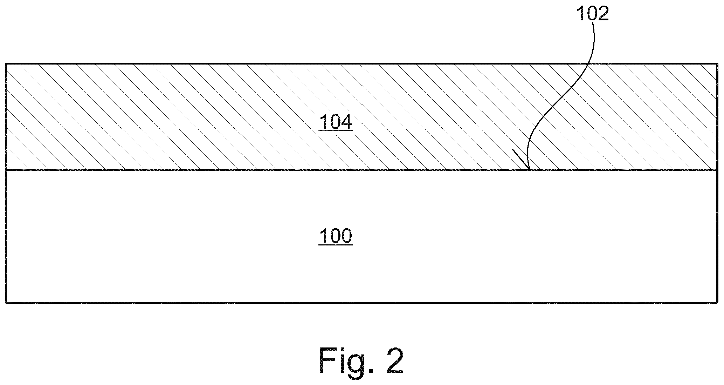

Referring to Fig. 2, a type III-V semiconductor layer 104 is formed on the growth surface 102 of the semiconductor base substrate 100.

The type III-V semiconductor layer 104 can be formed using a conventionally known epitaxy process in which the crystalline structure of the exposed surface is used as a template for the successive deposition of a number of epitaxial layers thereon. Optionally, a lattice transition layer (not shown) may be provided between the base substrate 100 and the type III-V semiconductor layer 104 to reduce lattice mismatch between the two regions. The lattice transition layer can be a III-V semiconductor -metal alloy (e.g., AIGaN) with a gradually diminishing metal content, for example.

According to the presently claimed invention, the type III-V semiconductor layer 104 includes a heterojunction in which two III-V semiconductor regions having different bandgaps (GaN and AIGaN) adjoin one another so as to form a two-dimensional carrier gas (e.g., a 2DEG). This two-dimensional carrier gas can be used to form a high mobility channel for a power semiconductor device.

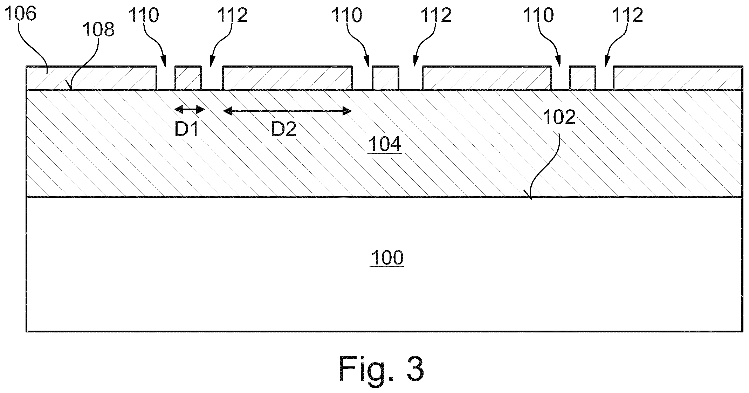

Referring to Fig. 3, a lithography mask 106 is formed on an upper surface 108 of the type III-V semiconductor layer 104. Generally speaking, the lithography mask 106 can include any kind of photoresist material that is compatible with photolithography. The lithography mask 106 has been patterned with first and second openings 110, 112 that expose the upper surface 108 of the type III-V semiconductor layer 104 from the lithography mask 106. The first and second openings 110, 112 are spaced apart from one another by a first distance D1. Each of the sets of the first and second openings 110, 112 are spaced apart from one another by a second distance D2. According to an embodiment, the second distance D2 is greater than the first distance D1.

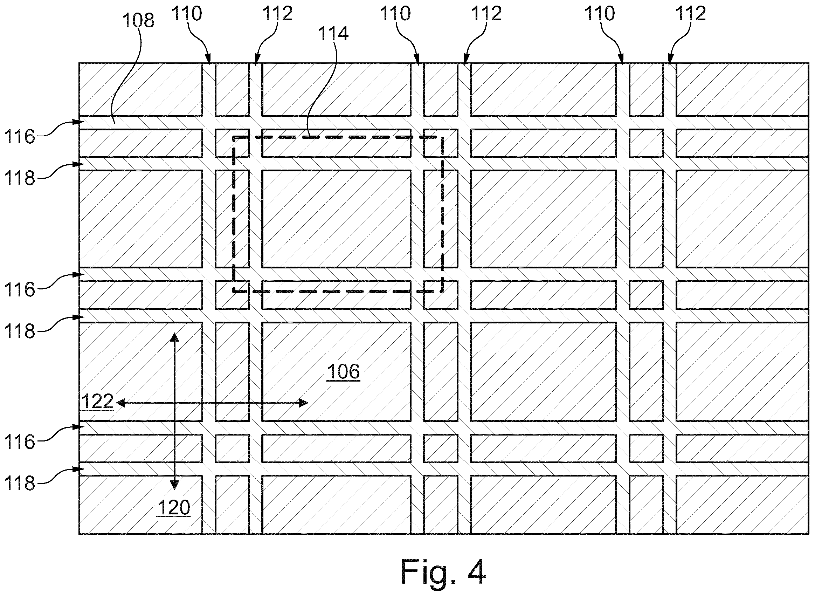

Referring to Fig. 4, a plan view of the wafer with the lithography mask 106 is depicted. Fig. 4 is a close up view that does not show the outer lateral edges of the wafer. The pattern shown in Fig. 4 can be repeated up to the outer lateral edges of the wafer. The lithography mask 106 has been patterned such that the openings in the lithography mask 106 have the shape of a dicing pattern for a semiconductor wafer. A peripheral edge 114 of each die is defined by the first and second openings 110, 112 and third and fourth openings 116, 118 that intersect with the first and second openings 110, 112.

In general, the sets of the first, second, third and fourth openings 110, 112, 116, 118 can be patterned to form any desired geometry for the peripheral edge 114 of the dies. According to a particular embodiment, the third and fourth openings 116, 118 are spaced apart from one another by the first distance D1, i.e., the same distance that separates the first and second openings 110, 112 from one another, and each set of the third and fourth openings 116, 118 is spaced apart from one another by the second distance D2, i.e., the same distance between sets of the first and second openings 110, 112. Additionally, the first and second openings 110, 112 extend along a first trench length direction 120 and the third and fourth openings 116, 118 extend along a second trench length direction 122 that is perpendicular to the first trench length direction 120. As a result, a square dicing pattern is provided.

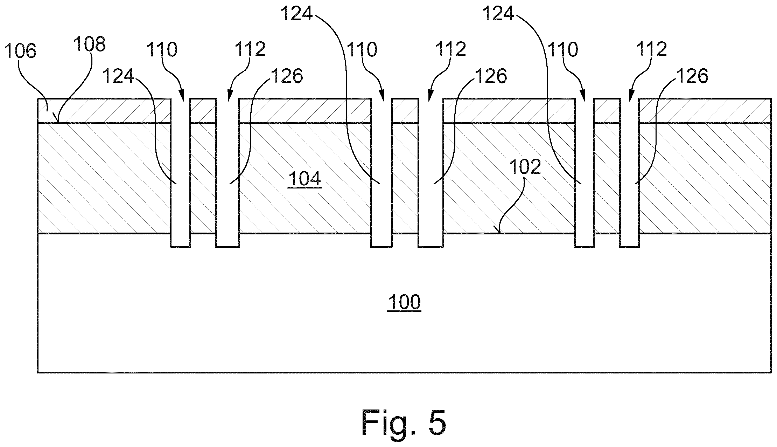

Referring to Fig. 5, first and second trenches 124, 126 are formed in the type III-V semiconductor layer 104. The first and second trenches 124, 126 are formed by an etching process in which semiconductor material that is exposed from the first and second openings 110, 112 of the lithography mask 106 is removed from the type III-V semiconductor layer 104. In general, this etching process can include any conventionally known etching technique, e.g., wet, dry, plasma, anisotropic, etc.

From a plan view perspective of the wafer, the first and second trenches 124, 126 have the geometry of the first and second openings 110, 112 illustrated in Fig. 4. That is, the sidewalls of the first and second trenches 124, 126 extend along the first trench length direction 120. Third and fourth trenches (not shown), which correspond to the third and fourth openings 116, 118 and are formed by this etching process, extend along the second trench length direction 122 and intersect with the first and second trenches 124, 126.

The first and second trenches 124, 126 are formed to vertically extend from the upper surface 108 of the type III-V semiconductor layer 104 at least to the growth surface 102 of the base substrate 100. That is, the etching process is carried out until all of the type III-V semiconductor material is removed and the bottom of the first and second trenches 124, 126 reaches base substrate 100. In the depicted embodiment, the first and second trenches 124, 126 extend further into the base substrate 100 such that the bottom of the first and second trenches 124, 126 is beneath the growth surface 102.

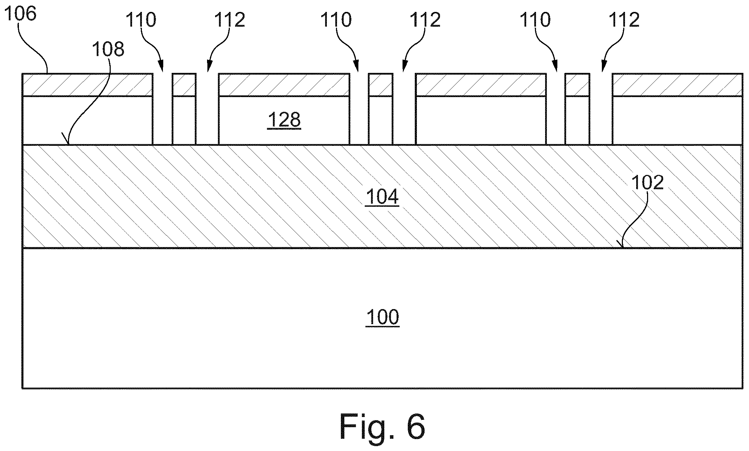

Referring to Figs. 6-7, a method for forming the first and second trenches 124, 126 is depicted according to another embodiment. Different to the technique described with reference to Figs. 3-5, according to this technique a first hard mask layer 128 is used in addition to the lithography mask 106. The first hard mask layer 128 can be formed from any material that is resistant to certain etchant materials. For example, the hard mask layer 128 can be an oxide layer, such as a layer of silicon dioxide (SiO₂). The first hard mask layer 128 is formed on the type III-V semiconductor layer 104 after the epitaxial growth step. After forming the hard mask layer 128, the lithography mask 106 is formed on the hard mask layer 128. The lithography mask 106 can have the same composition and geometry as previously described with reference to Figs. 3 and 4.

Referring to Fig. 6, after forming the lithography mask 106, a first etching step is performed to structure the hard mask layer 128 with a corresponding geometry as the lithography mask 106. This first etching step can be a plasma etching step, for example. After the first etching step, the openings formed in the hard mask layer 128 expose the first type III-V semiconductor in with a patterned geometry, such as the patterned geometry shown in Fig. 4, for example.

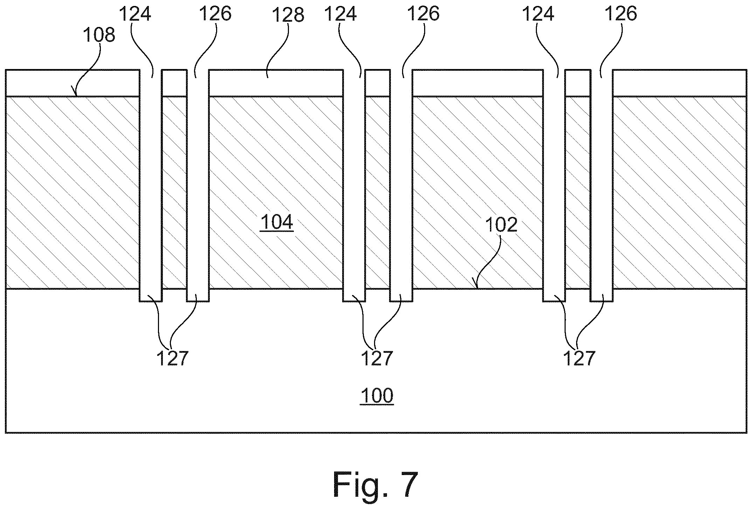

Referring to Fig. 7, first and second trenches 124, 126 are formed in the type III-V semiconductor layer 104. In a similar manner as previously described, the first and second trenches 124, 126 can be formed by etching away exposed type III-V semiconductor material until the bottom of the first and second trenches 124, 126 reaches the base substrate 100. In general, this can etching process can include any conventionally known etching process, e.g., wet, dry, plasma, anisotropic, etc. In some embodiments, after reaching the base substrate 100, a portion of the growth surface 102 of the base substrate 100 is etched away forming an indentation or groove 127, depending on the lateral form of the trenches 124, 126 in the growth surface 102. This indentation or groove 127 forms the bottom of the first and second trenches 124, 126 and provides the base and adjoining portion of the sidewalls of the trenches 124, 126.

The technique described with reference to Figs. 3-5 and the technique described with reference to Figs. 6-7 provide different advantages. The technique described with reference to Figs. 6-7 is better suited for deeper trench etching because the hard mask layer 128 protects the upper surface 108 of the type III-V semiconductor layer 104 during long etching cycles by providing a barrier against the etchant. If the etching process is sufficiently long, the technique described with reference to Figs. 3-5 may not be suitable because the lithography mask 106 can be completely removed and the underlying type III-V semiconductor layer 104 becomes damaged. However, for shallower trench etching, the technique described with reference to Figs. 3-5 is suitable and the extra hard mask and patterning steps of Figs. 6-7 can be omitted.

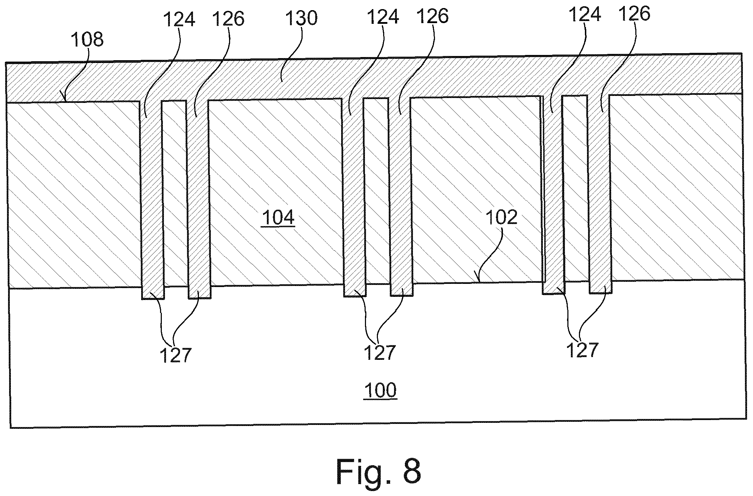

Referring to Fig. 8, after trenches are formed according to either one of the techniques described above, the first and second trenches 124, 126 are filled with a filler material 130. In general, the filler material 130 can be any material that is different from material of the type III-V semiconductor layer 104. Examples of the filler material 130 includes conductive materials, semiconducting materials, and electrical insulators. Exemplary conductive filler materials 130 include metals and metal alloys, such as tungsten, aluminum and alloys thereof. Exemplary semiconducting filler materials 130 include polycrystalline semiconductors such as polysilicon. These polycrystalline semiconductors can be intentionally doped to provide a desired conductivity. Exemplary electrical insulating filler materials 130 include semiconductor oxides such as silicon dioxide (SiO₂), silicon nitride (SiN) or silicon oxynitride (SiOₓNₓ).

According to one embodiment, the first and second trenches 124, 126 are configured to include a diode. This can be done by appropriately configuring the filler material 130. For example, the filler material 130 can be configured with a junction between two different polysilicon regions having a different doping type and/or concentration. Alternatively, metal can be formed in or above the first and second trenches 124, 126 so as to form a Schottky junction. According to another option, an electrical insulator (e.g., silicon dioxide) is provided between regions of doped filler material 130 to form a PIN diode.

According to another embodiment, the first and second trenches 124, 126 are configured to include a vertical electrical connector. This can be done by filling the first and second trenches 124, 126 with an electrical conductor, such as polysilicon or a metal. As a result, a low resistance path exists between the top and bottom of the first and second trenches 124, 126.

According to another embodiment, the first and second trenches 124, 126 are configured as electrical isolation structures. This can be done by filling the first and second trenches 124, 126 with an electrical insulator, such as silicon dioxide (SiO₂), silicon nitride (SiN) or silicon oxynitride (SiOₓNₓ). As a result, the first and second trenches 124, 126 electrically isolate lateral sections of the type III-V semiconductor layer 104 from one another.

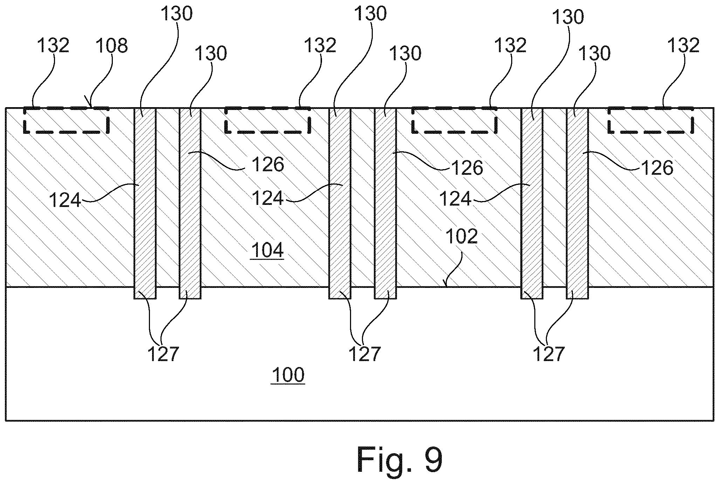

Referring to Fig. 9, the filler material 130 has been removed from the upper surface 108 of the type III-V semiconductor layer 104. As a result, the filler material 130 is disposed only in the first and second trenches 124, 126. Removing the filler material 130 may be done using an etchback process or a planarization technique, such as CMP (chemical mechanical planarization). Subsequently, a cleaning process can be performed to remove stray particles from the from the upper surface 108.

After the filler material 130 has been removed from the upper surface 108 of the type III-V semiconductor layer 104, device processing is performed. During device processing, active semiconductor devices, e.g., transistors, diodes, etc. are formed in the type III-V semiconductor layer 104. A location 132 of these active devices is depicted in Fig. 8. Exemplary active device features include input and output terminals, e.g., source, drain, collector, emitter, anode, cathode, etc., control terminals (in the case of transistors), e.g., gate, base etc., contact structures, e.g., source, body contacts, insulating layers, e.g., gate dielectrics, interconnect metallization. Generally speaking, these device processing steps can include a wide variety of known device formation steps, e.g., etching, deposition, doping, masking, etc. Exemplary processing steps include contact formation, e.g., etching and deposition of a conductive material, gate formation, e.g., deposition and structuring of an insulator and gate electrode, interconnect formation, e.g., deposition and etching of dielectric and metallization layers, etc. In the case of a GaN based HEMT, the devices can be configured to control an electrically conductive 2DEG that is beneath the upper surface 108 of the type III-V semiconductor layer 104 and extends parallel to the upper surface 108. This is just one example, and any of a wide variety of device configurations are possible.

According to some embodiments, elements that are formed in the first and second trenches 124, 126 are electrically connected to the active semiconductor devices. For example, in the case that the first and second trenches 124, 126 are configured with diodes as described above, these diodes can be electrically connected to the active semiconductor devices. In one particular example, an HEMT device is formed in the type III-V semiconductor layer 104 and a diode that is formed in one of the first trenches is connected in parallel with the HEMT device. According to another embodiment, the first and second trenches 124, 126 are used as a vertical electrical connector to provide electrical access to the active semiconductor device at a rear side of the substrate.

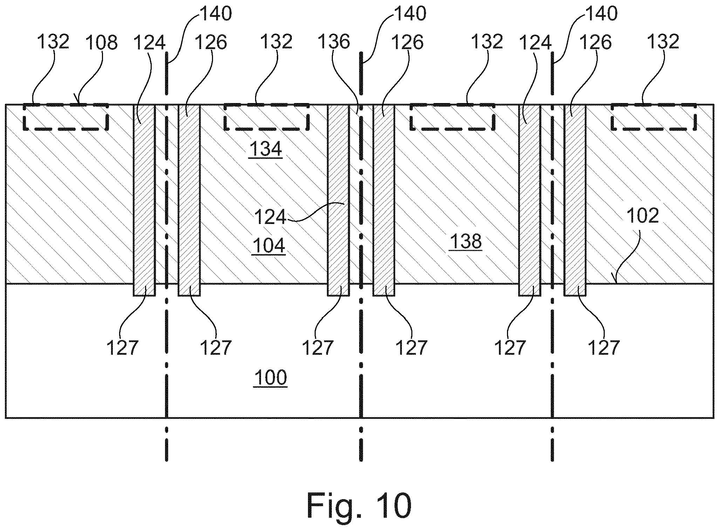

Referring to Figs. 10, after device processing, a cutting process can be performed to separate the wafer into discrete semiconductor chips. From the cross sectional view of Fig. 10, the first and second trenches 124, 126 delineate the type III-V semiconductor layer 104 into various lateral sections. More particularly, for a given set of the first and second trenches 124, 126, a first lateral section 134 is disposed on one side of the first trench 124, a second lateral section 136 is disposed between the first and second trenches 124, 126, and a third lateral section 138 is disposed on one side of the second trench 126. The cut is formed in the second lateral section 136 of the type III-V semiconductor layer 104. The cut is formed along a cutting line 140 that extends through the type III-V semiconductor layer 104 and the base substrate 100. According to an embodiment, the cutting line 140 extends along a plane that is parallel to the first trench length direction 120. That is, the cutting line 140 extends parallel to the first and second trenches 124, 126 from the plan view representation of Fig. 4. Moreover, the cutting line 140 may be perpendicular to the upper surface 108 of the epitaxial layer. A corresponding cut may be formed between intersecting pairs of third and fourth trenches that intersect with the first and second trenches 124, 126. That is, the cuts may be formed in the first and second trench length directions 120, 122 as described with reference to Fig. 4.

The cut may be formed using a mechanical separation technique or a laser separation technique, for example. According to an embodiment, the cut is formed using a mechanical sawing process. In the mechanical sawing process, a saw moves through the substrate along the cutting line 140 that is between the first and second trenches 124, 126.

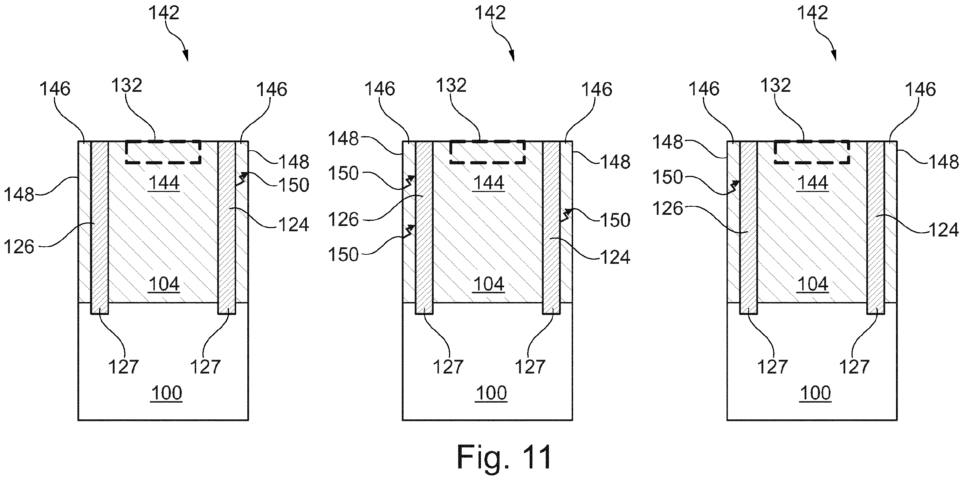

Referring to Fig. 11, the wafer has been separated into a plurality of discrete semiconductor chips 142 by the above described separation technique. Each of the semiconductor chips 142 contain a set of the first and second trenches 124, 126 that are filled with the filler material 130. Fig. 11 depicts the semiconductor chips 142 from a cross-sectional perspective. According to an embodiment, the semiconductor chips 142 contain a set of the third and fourth trenches that intersect with the first and second trenches 124, 126. As a result, the central lateral section 144 of the type III-V semiconductor layer 104 is completely enclosed by trenches containing the filler material 130. The active devices are contained within these central lateral sections 144. Moreover, the outer lateral sections 146 of the type III-V semiconductor layer 104 that extend to the edge sides 148 of the semiconductor chips 142 are physically decoupled from the central lateral sections 144. As previously explained, the first and second trenches 124, 126 can include elements (e.g., diodes, electrical connectors) that are connected to the active devices.

Due to the separation process, the semiconductor chips 142 contain a number of cracks 150 in the second lateral sections 136. During separation, cracks 150 propagate away from the separation mechanism (e.g., the saw) and towards the central lateral sections 144 of each semiconductor chip 142. As can be seen, the location and number of these cracks 150 can vary from chip to chip. Due to the presence of the first and second trenches 124, 126 that are filled with the filler material 130, the cracks 150 do not reach the active semiconductor devices. That is, the presence of the trenches and the filler material 130 interrupts the crystalline structure of the type III-V semiconductor layer 104 and therefore prevents any crack 150 that forms in the outer lateral sections 146 from extending any further. As a result, any crack that arises during the die separation process is contained within the outer lateral sections 146. Thus, the semiconductor chips 142 remain fully functional as the active devices are not damaged by the cracks 150.

Referring to Figs. 12-15, a semiconductor wafer rotation technique is depicted. This semiconductor wafer rotation technique can be used alone, combined with the methods described with reference to Figs. 1-11 or can be used with other methods, for example methods in which a single trench is formed between the central lateral sections containing the active devices or methods in which one or more trench are formed in the epitaxial layer. As will be explained in further detail below, this wafer rotation technique advantageously mitigates the possibility of the substrate cracking or breaking along a cleavage plane.

Referring to Fig. 12, a plan view and a side view of a semiconductor base substrate 100 is depicted, according to an embodiment. In addition, various crystallographic planes (i.e., lattice planes) of the underlying crystalline structure of the semiconductor base substrate 100 are depicted. In the plan view representation of Fig. 12A, the <110> plane 152, the <011> plane 154 and the <101> plane 156 of a silicon <111> wafer providing the semiconductor base substrate 100 are depicted at the growth surface 102. In the cross sectional view representation of Fig. 12B, the (111) plane forming the upper surface of the semiconductor base substrate 100 is depicted and indicated by the arrow 158 indicating the <111> direction.

Due to the mechanical properties of crystal structures, the semiconductor base substrate 100 has a tendency to break more easily along some particular crystallographic planes than along other crystallographic planes. That is, the mechanical strength of the substrate varies depending upon how the application of force relates to the crystallographic orientation of the semiconductor material. The semiconductor base substrate 100 shown in Fig. 12A and 12B is susceptible to mechanical cleavage along a preferred cleavage plane of the substrate 100 when the force applied to the substrate aligns with this cleavage plane. For a semiconductor base substrate 100 in the form of a <111> silicon wafer, preferred cleavage planes include {110}, {011} and {101}. From the perspective of Fig. 12A, any force that aligns with the <110> plane 152, the <011> plane 154 or the <101> plane 156 will create a separation force along one of these planes. In the context of ordinary semiconductor wafer processing and handling techniques, cleavage of the semiconductor base substrate 100 along one of the preferred cleavage planes of the <111> substrate 100 can be possible due to this phenomena.

In the case of an epitaxial layer grown on the semiconductor base substrate 100, the orientation of the underlying semiconductor base substrate 100 may play an important role in the mechanical strength of the device. In general, the provision of additional epitaxial layer, such as a type III-V semiconductor layer, on the semiconductor base substrate 100 increases the mechanical strength of the device. However, if this additional epitaxial layer includes trenches that are aligned with one of the preferred cleavage planes of the semiconductor base substrate 100, the trenches may act as a pre-crack and increase the likelihood of cleavage along this preferred cleavage plane of the substrate 100, where the crack propagates from the base of the trench.

In some embodiments, the base of the trench is positioned in the semiconductor substrate so that the base of the trench is formed by an indentation or groove in the upper surface of the semiconductor base substrate. If the trench is aligned with a preferred cleavage plane of the semiconductor base substrate, the indentation or groove may act as a pre-crack and increase the likelihood of cleavage and/or undesirable cracking propagating from the base of the trench. This can lead to partial or complete breakage of the semiconductor base substrate 100, and can require the part to be discarded due to complete device failure.

The semiconductor base substrate 100 includes an indicator feature 162 that indicates a crystallographic direction of the semiconductor base substrate 100. In some embodiments, this indicator feature 162 is a flat edge portion 160. This indicator feature 162 is typically used during manufacture to position the semiconductor base substrate 100 in various apparatus, for example, in a wafer holder during deposition of epitaxial layers on the semiconductor base substrate 100 and during singulation or dicing of the semiconductor base substrate 100 to form semiconductor dies with active devices from the semiconductor base substrate 100.

If the flat edge portion 160 is used to orientate the semiconductor base substrate 100 in apparatus, the singulation lines 170, 172 along which the substrate 100 is singulated or diced or cut to form individual dies from the substrate 100 commonly extend substantially perpendicular or parallel to the flat edge portion 160. If one or more trenches are formed, each having a trench length direction 164, 166, the trench length direction 164, 166 commonly extends substantially perpendicular or parallel to the flat edge portion 160. These trench length directions 164, 166 are substantially perpendicular to one another, whereby one set of trench length directions 164 extend perpendicular to the flat edge portion 160 and one set of trench length directions 166 extend parallel to the flat edge portion 160.

If the trench length directions 164 or 166 are aligned with a preferred cleavage plane of the semiconductor base substrate 100, this may result in the trench acting as a pre-crack and lead to undesirable cleavage or cracking of the semiconductor base substrate 100 that propagates from the base of the trench into the active devices grown on the semiconductor base substrate 100 and/or into the semiconductor base substrate 100 and may lead to breakage of the semiconductor base substrate.

In embodiments including a <111> silicon wafer as the semiconductor base substrate, the flat edge portion 160 may be formed along the <110> direction. Using this information, the orientation of the <110> direction 152, the <011> direction 154 and the <101> direction 156 can be extrapolated. For a silicon wafer having a <111> growth surface, i.e. a <111> silicon wafer, If the flat edge portion 160 is formed along the (110) plane, the trench length directions 166 as illustrated in Fig. 12A are aligned with the <110> direction indicated by arrow 152 which is a preferred cleavage plane.

In order to avoid force being exerted along a preferred crystallographic cleavage plane due to the formation of one or more trenches formed along the trench length direction 166, the relative angle or orientation between the trenches and their trench length direction 166 and the crystallographic orientation of the semiconductor base substrate 100 may be changed so that the trenches with the trench length direction 166 are not aligned with the preferred cleavage planes of the semiconductor base substrate 100. Similarly, the relative angle or orientation between the trench length direction 164 of the perpendicular trenches and the crystallographic orientation of the semiconductor base substrate 100 may be changed so that the trenches with the trench length direction 164 are not aligned with the preferred cleavage planes of the semiconductor base substrate 100.

This reorientation of the trenches with respect to the preferred cleavage planes of the base substrate 100 may be performed independently of the orientation of the singulation lines 170, 172 with the respect to the preferred cleavage planes. For example, one or more of the singulation lines 170, 172 may be aligned or parallel to a preferred cleavage plane, whereas the trenches are unaligned or non-parallel with all preferred cleavage planes. In some embodiments, the trench length directions 164, 166 and the singulation lines 170, 172 may be orientated such that both the trench length directions 164, 166 and the singulation lines 170, 172 are unaligned or non-parallel with all preferred cleavage planes. In some embodiments, the trench length direction 164 and the singulation line 170 are parallel to one another, the trench length direction 166 and the singulation line 172 are parallel to once another and both the trench length directions 164, 166 and the singulation lines 170, 172 are unaligned or non-parallel with all of the preferred cleavage planes.

In some embodiments, this realignment of the trenches with respect to the preferred cleavage planes of the base substrate may be performed as illustrated in Fig. 13A. As is illustrated in Figure 13A, the trench length directions 164 are no longer parallel to the <110> direction of the semiconductor base substrate 100. The trench length directions 164 are also not parallel to the <101> or <011> directions. Similarly, the trench length directions 166 are not parallel to the <110>, <101> or <011> directions.

Referring to Fig. 13, a method of orienting the semiconductor base substrate 100 prior to epitaxially growing semiconductor material on the semiconductor base substrate 100 and forming trenches therein is depicted. According to the method, an indicator feature 162 that indicates a crystallographic orientation of the semiconductor base substrate 100 is used to determine the crystallographic planes of the semiconductor base substrate 100. The indicator feature 162 can be any physical feature on the semiconductor base substrate 100, such as a notch, alignment mark, irregularity, etc., that enables the user to determine the crystallographic planes of the substrate. In the depicted example, the peripheral edge of the semiconductor base substrate or wafer 100 is mostly rounded but includes a flat edge portion 160 that provides the indicator feature 162.

According to an embodiment, the flat edge portion 160 of the substrate 100, i.e., the indicator feature 162, is positioned in the substrate 100 such that the flat edge portion 160 is not perpendicular to the <110> direction indicated by arrow 152 and forms an angle, α, to the{110}planes indicated by the line 160' along which the flat portion 160 of the semiconductor substrate 100 illustrated in Fig. 12 is positioned.. The flat edge portion 160 forms an inclined angle with the <110> direction that is greater than 0° and less than 90°.

The relative angular position between the trenches having trench length directions 164, 166 and the preferred cleavage planes 152, 154, 156 has been adjusted so that the trench length directions 164, 166 are not parallel (i.e. are antiparallel) and are not perpendicular (i.e. are antiperpendicular) to the <110>, <101> or <011> directions. Therefore, when the semiconductor substrate 100 of Fig. 13 is positioned in manufacturing apparatus using the indicator 162, the crystallographic structure, in particular the preferred cleavage planes, of the semiconductor substrate 100 is reoriented with respect to the apparatus compared to the orientation of the semiconductor substrate 100 illustrated in Fig. 12.

Consequently, in an embodiment, <111> silicon wafer is provided that comprises a planar growth surface 102 having a (111) plane and a flat edge. The flat edge that is antiparallel and antiperpendicular to the {110}, {011} and {101}.crystallographic planes of the base substrate. The semiconductor substrate may have the form of a disc with a circular contour, whereby one portion of the circular contour is removed to form that flat edge.

In some embodiments, the trenches may be formed such that the central lateral portions 144, in which the active device are formed, are formed between, and bounded by, the trenches having trench length directions 164, 166. The central lateral portions 144 are arranged in a grid separated from the immediate neighbor by a scribeline or saw street at the singulation lies 170, 172. In some embodiments, the semiconductor substrate is singulated by cutting parallel to the trench length directions 164, 166 in the saw street. Consequently, boundary of the central lateral portions 144 and side faces of the dies formed from the central lateral portions 144 after singulation along the lines 164, 166 are also reoriented with respect to the crystallographic orientation of the semiconductor substrate 100.

In some embodiments, one or more trenches may be formed in the semiconductor layer, such as the type III-V semiconductor layer 104, have length directions 164, 166 that are antiparallel and antiperpendicular to the preferred cleavage planes and at least one of the singulation lines 170, 172 is, however, parallel or perpendicular to one of the preferred cleavage planes.

Using to the technique shown in Fig. 13, the semiconductor base substrate 100 may be repositioned with one or more trench length formation directions in mind such that the trench formation directions are not parallel to the preferred cleavage planes of the semiconductor base substrate 100. The trench length formation directions refer to a direction that extends parallel to the sidewalls of trenches (i.e., length directions of the trenches) that will eventually be formed in an epitaxial layer that is formed on the semiconductor base substrate 100.

In figures 12 to 15, first and second trench length formation directions are depicted by the lines 164, 166. The first and second trench length formation directions 164, 166 are perpendicular to one another. The position of the indicator feature 162 is used to rotate the crystallographic orientation of the semiconductor base substrate 100 with respect to the indicator feature 162 prior to epitaxial growth and trench formation. The semiconductor base substrate 100 is rotated in the direction shown such that the trench formation directions 164, 166 are antiparallel to a crystallographic cleavage plane of the substrate. In the depicted example, this is achieved by rotating the crystallographic orientation of the substrate 100 such that the <110> plane 152, the <011> plane 154, and the <101> plane 156 of the semiconductor base substrate 100 are antiparallel and anti-perpendicular to first and second trench length formation directions 164, 166. In general, the angle of rotation can be any angle between 0 and 360 degrees other than the exact angles that result in the <110> plane 152, the <011> plane 154, and the <101> plane 156 being parallel or perpendicular to the first and second trench length formation directions 164, 166. Starting from the orientation shown in Fig. 12, the rotation angles that result in the <110> plane 152, the <011> plane 154, and the <101> plane 156 being parallel or perpendicular to the first and second trench length formation directions 164, 166 include rotations of 15°, 30°, 60°, 90°, etc. through each quadrant. Thus, by rotating the substrate by any angle other than these angles, the desired orientation can be achieved. Optionally, a margin of 1-2 degrees can be used (e.g., angles other than 13°- 17°, 28°- 32°, etc.) to avoid near alignment with a cleavage plane.

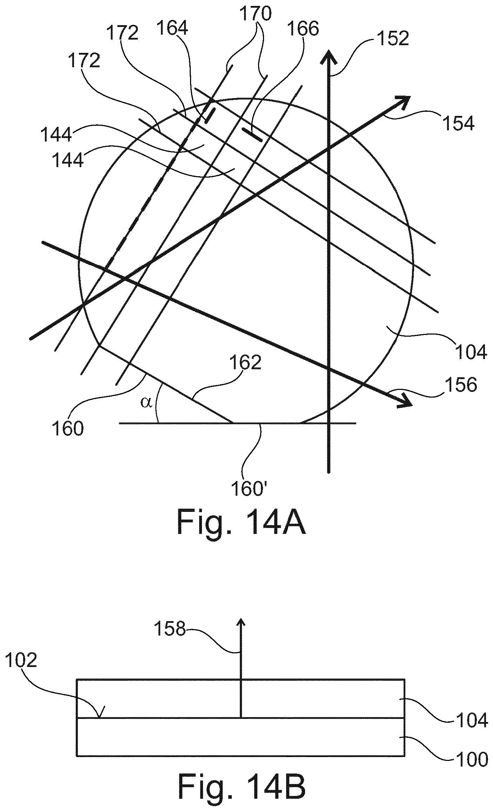

Referring to Fig. 14, a type III-V semiconductor layer 104 is epitaxially formed on the growth surface 102. The type III-V semiconductor layer 104 can be formed according to the techniques described with reference to Fig. 3. Immediately adjacent ones of the central lateral sections 144 or component positions that are to form dies or chips are separated by singulation lines 170 which extend perpendicularly to the flat edge portion 160 and by singulation lines 172 which extend parallel to the flat edge portion 160. The central lateral sections 144 are arranged in columns that are orientated with respect to the crystallographic orientation of the semiconductor base substrate 100 such that they are unaligned, i.e. antiparallel, with the preferred cleavage planes indicated by arrows 152, 154, 156.

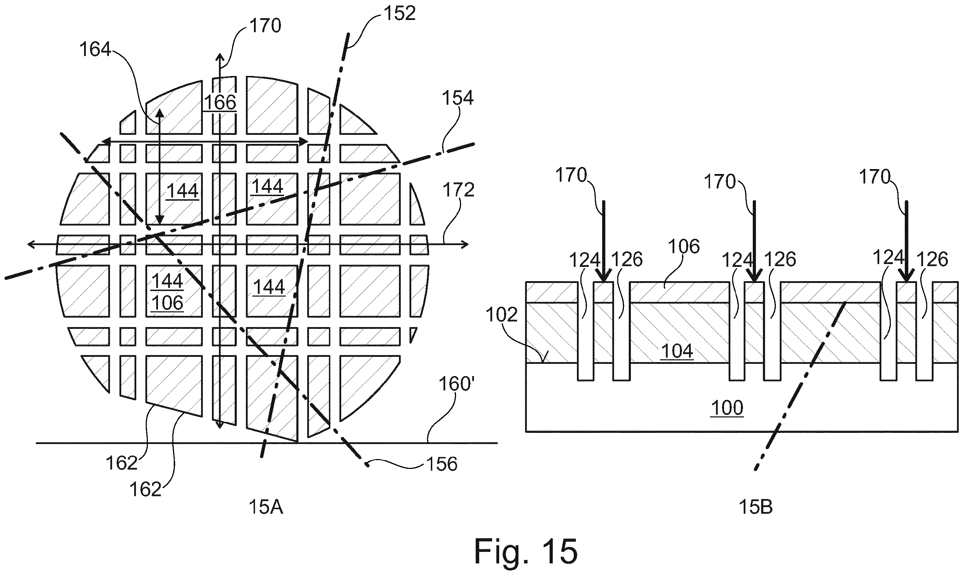

In some embodiments, one or two trenches having a length direction 164 or 166 are formed parallel to the singulation direction 170, 172, respectively. Referring to Fig. 15, trenches are formed in the type III-V semiconductor layer 104. In some embodiments, the trench length directions 164, 166 extend at an inclined angle to the indicator 162 and also at an inclined angle to the preferred cleavage planes 152, 154, 156 so that the trench length directions 164, 166 and trenches are antiparallel and antiperpendicular to both the indicator 162 and to the preferred cleavage planes 152, 154, 156. The central lateral sections 144 are arranged in columns that are orientated with respect to the crystallographic orientation of the semiconductor base substrate 100 such that they are antiparallel and to the preferred cleavage planes. The trenches may be formed according to any of the techniques described with reference to Figs. 3-7.

According to an embodiment, the trenches are formed such that two parallel trenches are formed along each separation line 170, 172. The first and second trenches 124, 126 may be formed as previously described are parallel to the first trench length formation direction 164 and the third and fourth trenches as previously described are parallel to the second trench length formation direction 166. In this way, the first, second, third and fourth trenches are formed to be antiparallel to and antiperpendicular to the <110> plane 152, the <011> plane 154, and the <101> plane 156. As a result, the likelihood that mechanical force exerted on the trenches, for example during handling and processing, causes a crack to propagate from the trench into the substrate to break through the silicon substrate 100, in particular by propagation along one of the preferred cleavage planes of the <111> silicon substrate 100 is substantially reduced. After the formation of the trenches, the trenches can be filled, devices can be formed, and the substrate can be separated into discrete semiconductor chips 142 by cutting between the two parallel trenches 124, 126 along the singulation lines 170, 172.

A semiconductor die singulated from the semiconductor substrate illustrated in Figs. 13 to 15 comprises a semiconductor base substrate comprising a planar growth surface having a crystallographic direction, the semiconductor base substrate comprising preferred crystallographic cleavage planes. A type III-V semiconductor layer is epitaxially formed on the growth surface and at least one trench is formed in the type III-V semiconductor layer that extends to and optionally into the growth surface of the semiconductor base substrate. The trench has a trench length direction that is antiparallel to the preferred crystallographic cleavage planes. In the presently claimed invention, the semiconductor base substrate is a silicon wafer, the crystallographic direction of the planar growth surface is <111> and the preferred cleavage planes are {110}, {011} and {101}. The type III-V semiconductor layer comprises two or more Group III-nitride layers forming a heterojunction. The type III-V semiconductor layer may form a Group III-nitride based transistor device such as a HEMT (High Electron Mobility Transistor).

The term "substantially" encompasses absolute conformity with a requirement as well as minor deviation from absolute conformity with the requirement due to manufacturing process variations, assembly, and other factors that may cause a deviation from the ideal. Provided that the deviation is within process tolerances so as to achieve practical conformity and the components described herein are able to function according to the application requirements, the term "substantially" encompasses any of these deviations.

Spatially relative terms such as "under," "below," "lower," "over," "upper," and the like, are used for ease of description to explain the positioning of one element relative to a second element. These terms are intended to encompass different orientations of the package in addition to different orientations than those depicted in the figures. Further, terms such as "first," "second," and the like, are also used to describe various elements, regions, sections, etc. and are also not intended to be limiting. Like terms refer to like elements throughout the description.

As used herein, the term "lateral," "laterally," and the like refer to a direction that is parallel to the main surface of the substrate. The term "vertical," "vertically," and the like refer to a direction that is perpendicular to the main surface of the substrate. Features that "extend" in the vertical direction are not necessarily parallel to the vertical direction, but rather have a vector component that is parallel to the vertical direction.

As used herein, the terms "having," "containing," "including," "comprising," and the like are open-ended terms that indicate the presence of stated elements or features, but do not preclude additional elements or features. The articles "a," "an," and "the" are intended to include the plural as well as the singular, unless the context clearly indicates otherwise.

With the above range of variations and applications in mind, it should be understood that the present invention is not limited by the foregoing description, nor is it limited by the accompanying drawings. Instead, the present invention is limited only by the following claims.

## Claims

1. A method of forming a semiconductor device, comprising:
providing a silicon base substrate (100) comprising a substantially planar growth surface (102) and one or more preferred crystallographic cleavage planes and an epitaxial type III-V semiconductor layer (104) on the planar growth surface (102), wherein the growth surface (102) has a (111) plane and the preferred cleavage planes are the *{110}, {011}* and *{101}* crystallographic planes of the silicon base substrate (100), wherein the type III-V semiconductor layer (104) comprises a heterojunction, in which a GaN region and an AIGaN region, which have different bandgaps, adjoin one another so as to form a two-dimensional carrier gas;
forming a mask (106) on an upper surface (108) of the type III-V semiconductor layer (104) with openings that expose the upper surface (108) of the type III-V semiconductor layer (104);
forming a first trench (124) by an etching process and removing semiconductor material that is exposed from the openings of the mask (106) from the type III-V semiconductor layer (104), the first trench (124) vertically extending from the upper surface (108) of the type III-V semiconductor layer (104) at least to the planar growth surface (102);
wherein the first trench (124) has a first trench length direction (164) that is non parallel and unaligned to the one or more preferred crystallographic cleavage planes.

2. The method according to claim 1, wherein the first trench (124) extends into the planar growth surface (102) such that an indentation in the planar growth surface (102) of the silicon base substrate (100) forms the base of the first trench (124).

3. The method according to claim 1 or claim 2, further comprising forming at least one second trench that vertically extends from an upper surface (108) of the type III-V semiconductor layer (104) at least to the planar growth surface (102), the second trench extending perpendicularly to the first trench and having a second trench length direction (166) that is non parallel and unaligned to the one or more preferred crystallographic cleavage planes.

4. The method according to any one of claims 1 to 3, further comprising:
forming device structures in component positions of the type III-V semiconductor layer (104), the component positions being arranged in a grid of rows and columns, each having a direction, wherein the direction is non parallel and unaligned with the one or more of the crystallographic cleavage planes.

5. The method according to any one of claims 1 to 4, further comprising:
forming a cut that separates the type III-V semiconductor layer (104) and the silicon base substrate (100) into two discrete semiconductor chips,
wherein the cut is formed along a first cutting plane that is non parallel and unaligned to the one or more preferred crystallographic cleavage planes of the silicon base substrate (100).

6. The method according to claim 5, wherein the cut is formed by mechanical sawing or a laser separation technique.

7. The method according to any one of claims 1 to 6, wherein the silicon base substrate (100) comprises an indicator feature (162) that indicates a crystallographic orientation of the silicon base substrate (100), the method further comprising:
using the indicator feature (162) to orient the first trench (124) such that the first trench length direction (164) extends along the plane that is non parallel and unaligned to the one or more preferred crystallographic cleavage planes of the silicon base substrate (100).

8. The method according to any one of claim 1 to 6, wherein the semiconductor base substrate comprises an indicator feature (162) that identifies the preferred cleavage planes of the silicon base substrate (100), the method further comprising:
positioning the indicator feature (162) such that the preferred cleavage planes of the silicon base substrate (100) are antiparallel and antiperpendicular to the indicator feature (162), wherein the indicator feature (162) is positioned such that the *{110}, {011}* and *{101}* crystallographic planes of the silicon base substrate (100) are non parallel and unaligned and non perpendicular to the indicator feature (162).

9. The method according to claim 8, wherein the indicator feature (162) is a flat edge and the method further comprises forming the first trench (124) such that it is parallel or perpendicular to the flat edge.

10. The method according to any one of claims 1 to 9, further comprising:
forming two first trenches (124, 126) extending parallel to one another along a first trench length direction (164), the first length direction (164) being antiparallel to the one or more preferred crystallographic cleavage planes of the silicon base substrate (100);
forming two second trenches extending parallel to one another along a second trench length direction (166) that is perpendicular to the first trench length direction (164) and non parallel and unaligned to the one or more preferred crystallographic cleavage planes of the silicon base substrate (100).

11. The method according to claim 10, wherein the type III-V semiconductor (104) layer and the silicon base substrate (100) are cut along a first cutting plane (170) that is parallel to the first trench length direction (164) and between the two first trenches (124, 126).

12. The method according to claim 11, wherein the two first trenches (124, 126) are formed to define first, second and third lateral sections of the type III-V semiconductor layer (104), the first lateral section being disposed on one side of the first trench (124), the second lateral section being disposed between the first and second trenches (124, 126), and the third lateral section being disposed on one side of the second trench (126), and wherein the cut is formed in the second lateral section.

13. The method of any one of claims 1 to 12, further comprising:
filling the first trench (124) with a filler material (130) that is different from material of the type III-V semiconductor layer (104), the filler material comprising any one or combination of: a semiconductor oxide, a polycrystalline material, and a metal.

14. The method of any one of clams 1 to 13, wherein the etching process comprises a wet, dry, plasma or anisotropic etching technique.

15. A semiconductor chip, comprising:
a semiconductor base substrate (100) comprising a planar growth surface (102) having a crystallographic direction, the semiconductor base substrate comprising preferred crystallographic cleavage planes; wherein the semiconductor base substrate (100) is a silicon wafer, the crystallographic direction of the planar growth surface (102) is <111> and the preferred cleavage planes are the *{110}, {011}* and *{101}*;
a type III-V semiconductor layer (104) epitaxially formed on the planar growth surface (102), wherein the type III-V semiconductor layer (104) comprises a heterojunction, in which a GaN region and an AIGaN region, which have different bandgaps, adjoin one another so as to form a two-dimensional carrier gas;
at least one etched trench (124) formed in the type III-V semiconductor layer (104) and that extends at least to the growth surface (102) of the semiconductor base substrate (100);
wherein the at least one trench (124) has a trench length direction (164) that is non parallel and unaligned to the preferred crystallographic cleavage planes.

16. The semiconductor chip of claim 15, wherein the type III-V semiconductor layer (104) forms a Group III-nitride based transistor device.

## Patentansprüche

1. Verfahren zum Bilden eines Halbleiterbauelements, umfassend:
Bereitstellen eines Siliziumbasissubstrats (100) umfassend eine im Wesentlichen planare Wachstumsoberfläche (102) und eine oder mehrere bevorzugte kristallografische Spaltebenen und eine Epitaxialtyp-III-V-Halbleiterschicht (104) auf der planaren Wachstumsoberfläche (102), wobei die Wachstumsoberfläche (102) eine *(111)*-Ebene aufweist und die bevorzugten Spaltebenen die kirstallografischen Spaltebenen *{110}*, *{011}* und *{101}* des Siliziumbasissubstrats (100) sind, wobei die Typ-III-V-Halbleiterschicht (104) einen Heteroübergang umfasst, bei dem ein GaN-Gebiet und ein AlGaN-Gebiet, die unterschiedliche Bandabstände aufweisen, aneinander grenzen, um ein zweidimensionales Trägergas zu bilden;
Bilden einer Maske (106) auf einer oberen Oberfläche (108) der Typ-III-V-Halbleiterschicht (104) mit Öffnungen, die die obere Oberfläche (108) der Typ-III-V-Halbleiterschicht (104) exponieren;
Bilden eines ersten Grabens (124) durch einen Ätzprozess und Beseitigen von Halbleitermaterial, das exponiert ist, von den Öffnungen der Maske (106) von der Typ-III-V-Halbleiterschicht (104), wobei sich der erste Graben (124) vertikal von der oberen Oberfläche (108) der Typ-III-V-Halbleiterschicht (104) mindestens bis zu der planaren Wachstumsoberfläche (102) erstreckt;
wobei der erste Graben (124) eine erste Grabenlängenrichtung (164) aufweist, die nicht parallel und unausgerichtet auf die eine oder die mehreren bevorzugten kristallografischen Spaltebenen verläuft.

2. Verfahren nach Anspruch 1, wobei sich der erste Graben (124) derart in die planare Wachstumsoberfläche (102) erstreckt, dass eine Vertiefung in der planaren Wachstumsoberfläche (102) des Siliziumbasissubstrats (100) die Basis des ersten Grabens (124) bildet.

3. Verfahren nach Anspruch 1 oder Anspruch 2, weiter umfassend das Bilden mindestens eines zweiten Grabens, der sich vertikal von einer oberen Oberfläche (108) der Typ-III-V-Halbleiterschicht (104) mindestens bis zu der planaren Wachstumsoberfläche (102) erstreckt, wobei sich der zweite Graben senkrecht zu dem ersten Graben erstreckt und eine zweite Grabenlängenrichtung (166) aufweist, die nicht parallel und unausgerichtet auf die eine oder die mehreren bevorzugten kristallografischen Spaltebenen erstreckt.

4. Verfahren nach einem der Ansprüche 1 bis 3, weiter umfassend:
Bilden von Bauelementstrukturen in Komponentenpositionen der Typ-III-V-Halbleiterschicht (104), wobei die Komponentenpositionen in einem Gitter von Zeilen und Spalten jeweils mit einer Richtung angeordnet sind, wobei die Richtung nicht parallel und unausgerichtet mit der einen oder den mehreren der kristallografischen Spaltebenen verläuft.

5. Verfahren nach einem der Ansprüche 1 bis 4, weiter umfassend:
Bilden eines Schnitts, der die Typ-III-V-Halbleiterschicht (104) und das Siliziumbasissubstrat (100) in zwei diskrete Halbleiterchips trennt,
wobei der Schnitt entlang einer ersten Schnittebene gebildet ist, die nicht parallel und unausgerichtet zu der einen oder den mehreren kristallografischen Spaltebenen des Siliziumbasissubstrats (100) verläuft.

6. Verfahren nach Anspruch 5, wobei der Schnitt durch mechanisches Sägen oder eine Lasertrenntechnik gebildet wird.

7. Verfahren nach einem der Ansprüche 1 bis 6, wobei das Siliziumbasissubstrat (100) ein Indikatormerkmal (162) umfasst, das eine kristallografische Orientierung des Siliziumbasissubstrats (100) anzeigt, wobei das Verfahren weiter umfasst:
Verwenden des Indikatormerkmals (162) zum Orientieren des ersten Grabens (124), so dass sich die erste Grabenlängenrichtung (164) entlang der Ebene erstreckt, die nicht parallel und unausgerichtet zu der einen oder den mehreren bevorzugten kristallografischen Spaltebenen des Siliziumbasissubstrats (100) verläuft.

8. Verfahren nach einem der Ansprüche 1 bis 6, wobei das Halbleiterbasissubstrat ein Indikatormerkmal (162) umfasst, das die bevorzugten Spaltebenen des Siliziumbasissubstrats (100) identifiziert, wobei das Verfahren weiter umfasst:
Positionieren des Indikatormerkmals (162), so dass die bevorzugten Spaltebenen des Siliziumbasissubstrats (100) antiparallel und antisenkrecht zu dem Indikatormerkmal (162) verlaufen, wobei das Indikatormerkmal (162) derart positioniert ist, dass die kristallografischen Ebenen *{110}, {011}* und *{101}* des Siliziumbasissubstrats (100) nicht parallel und unausgerichtet und nicht senkrecht zu dem Indikatormerkmal (162) verlaufen.

9. Verfahren nach Anspruch 8, wobei das Indikatormerkmal (162) eine flache Kante ist und das Verfahren weiter das Bilden des ersten Grabens (124) umfasst, so dass er parallel oder senkrecht zu der flachen Kante verläuft.

10. Verfahren nach einem der Ansprüche 1 bis 9, weiter umfassend:
Ausbilden von zwei ersten Gräben (124, 126), die sich parallel zueinander entlang einer ersten Grabenlängenrichtung (164) erstrecken, wobei die erste Längenrichtung (164) antiparallel zu der einen oder den mehreren bevorzugten kristallografischen Spaltebenen des Siliziumbasissubstrats (100) verläuft;
Bilden von zwei zweiten Gräben, die sich parallel zueinander und entlang einer zweiten Grabenlängenrichtung (166) erstrecken, die parallel zu der ersten Grabenlängenrichtung (164) und nicht parallel und unausgerichtet zu der einen oder den mehreren bevorzugten kristallografischen Spaltebenen des Siliziumbasissubstrats (100) verläuft.

11. Verfahren nach Anspruch 10, wobei die Typ-III-V-Halbleiterschicht (104) und das Siliziumbasissubstrat (100) entlang einer ersten Schnittebene (170) geschnitten werden, die parallel zu der ersten Grabenlängenrichtung (164) und zwischen den beiden ersten Gräben (124, 126) verläuft.

12. Verfahren nach Anspruch 11, wobei die zwei ersten Gräben (124, 126) ausgebildet sind zum Definieren eines ersten, zweiten und dritten lateralen Abschnitts der Typ-III-V-Halbleiterschicht (104), wobei der erste lateral Abschnitt auf einer Seite des ersten Grabens (124) angeordnet ist, der zweite lateral Abschnitt zwischen dem ersten und zweiten Graben (124, 126) angeordnet ist und der dritte laterale Abschnitt auf einer Seite des zweiten Grabens (126) angeordnet ist und wobei der Schnitt in dem zweiten lateralen Abschnitt gebildet ist.

13. Verfahren nach einem der Ansprüche 1 bis 12, weiter umfassend:
Füllen des ersten Grabens (124) mit einem Füllmaterial (130), das von dem Material der Typ-III-V-Halbleiterschicht (104) verschieden ist, wobei das Füllmaterial eine beliebige oder eine Kombination von Folgendem umfasst: einem Halbleiteroxid, einem polykristallinen Material und einem Metall.

14. Verfahren nach einem der Ansprüche 1 bis 13, wobei der Ätzprozess eine Nass-, Trocken-, Plasma- oder anisotrope Ätztechnik umfasst.

15. Halbleiterchip, umfassend:
ein Halbleiterbasissubstrat (100) umfassend eine planare Wachstumsoberfläche (102) mit einer kristallografischen Richtung, wobei das Halbleiterbasissubstrat bevorzugte kristallografische Spaltebenen umfasst; wobei das Halbleiterbasissubstrat (100) ein Siliziumwafer ist, die kristallografische Richtung der planaren Wachstumsoberfläche (102) *<111>* ist und die bevorzugten Spaltebenen *{110}, {011}* und *{101}* sind;
eine Typ-III-V-Halbleiterschicht (104), die epitaxial auf der planaren Wachstumsoberfläche (102) gebildet ist, wobei die Typ-III-V-Halbleiterschicht (104) einen Heteroübergang umfasst, bei dem ein GaN-Gebiet und ein AlGaN-Gebiet, die unterschiedliche Bandabstände aufweisen, aneinander grenzen, um ein zweidimensionales Trägergas zu bilden;
mindestens einen geätzten Graben (124), der in der Typ-III-V-Halbleiterschicht (104) gebildet ist und sich mindestens zu der Wachstumsoberfläche (102) des Halbleiterbasissubstrats (100) erstreckt;
wobei der mindestens eine Graben (124) eine Grabenlängenrichtung (164) aufweist, die nicht parallel und unausgerichtet zu den bevorzugten kristallografischen Spaltebenen verläuft.

16. Halbleiterchip nach Anspruch 15, wobei die Typ-III-V-Halbleiterschicht (104) ein Gruppe-III-Nitridbasiertes Transistorbauelement bildet.

## Revendications

1. Procédé de formation d'un dispositif à semi-conducteur dans lequel :
on se procure un substrat (100) à base de silicium comprenant une surface (102) de croissance sensiblement plane et un ou plusieurs plans préféré de clivage de cristalographique et une couche (104) épitaxiale de semi-conducteur de type III-V sur la surface (102) plane de croissance, dans lequel la surface (102) de croissance a un plan (111) et les plans préférés de clivage sont les plans {110}, {011} et {101} cristallographiques du substrat (10) de base en silicium, dans lequel la couche (104) de semi-conducteur de type III-V comprend une hétérojonction, dans lequel une région de GaN et une région de AlGaN, qui ont des bandes interdites différentes, sont adjointes l'une à l'autre de manière à former un gaz porteur à deux dimensions ;
on forme un masque (106) sur une surface (108) supérieure de la couche (104) de semi-conducteur de type III-V avec des ouvertures qui mettent à découvert la surface (108) supérieure de la couche (104) semi-conducteur de type III-V;
on forme un premier sillon (124) par une opération d'attaque et on élimine du matériau semi-conducteur qui est mis à découvert par les ouvertures du masque (106) de la couche (104) de semi-conducteur de type III-V, le premier sillon (124) s'étendant verticalement de la surface (108) supérieure de la couche (104) de semi-conducteur de type III-V au moins à la surface (102) plane de croissance ;
dans lequel le premier sillon (124) a une première direction (164) de sillon en longueur, qui n'est pas parallèle au un ou aux plusieurs plans préférés de clivage cristallographiques et n'est pas aligné sur ces plans.

2. Procédé suivant la revendication 1, dans lequel le premier sillon (124) s'étend dans la surface (102) plane de croissance de manière à ce qu'une indentation de la surface (102) plane de croissance du substrat (102) de base en silicium forme la base du premier sillon (124).

3. Procédé suivant la revendication 1 ou la revendication 2, dans lequel en outre on forme au moins un deuxième sillon, qui s'étend verticalement d'une surface (108) supérieure de la couche (104) de semi-conducteur de type III-V au moins à la surface (102) plane de croissance, le deuxième sillon s'étendant perpendiculairement au premier sillon et ayant une deuxième direction (166) de sillon en longueur qui n'est pas parallèle au un ou aux plusieurs plans préférés de clivage cristallographiques et n'est pas aligné sur ceux-ci.

4. Procédé suivant l'une quelconque des revendications 1 à 3, dans lequel en outre :
on forme des structures de dispositif dans des positions de composants de la couche (104) de semi-conducteur de type III-V, les positions de composants étant disposées suivant un réseau de rangées et de colonnes, ayant chacune une direction, dans lequel la direction n'est pas parallèle au un ou aux plusieurs des plans de clivage cristallographiques et n'est pas alignée sur eux.

5. Procédé suivant l'une quelconque des revendications 1 à 4, dans lequel en outre :
on forme une coupe, qui sépare la couche (104) de semi-conducteur de type III-V et de substrat (100) de base en silicium en deux puces discrètes de semi-conducteur
dans lequel on forme la coupe suivant un premier plan de coupe qui n'est pas parallèle au un ou aux plusieurs plan (s) préféré (s) de clivage cristallographiques du substrat (100) de base en silicium et qui n'est pas aligné sur eux.

6. Procédé suivant la revendication 5, dans lequel on forme la découpe par filage mécanique ou par une technique de séparation par laser.

7. Procédé suivant l'une quelconque des revendications 1 à 6, dans lequel le substrat (100) de base en silicium comprend un détail (162) indicateur, qui oriente le premier sillon (124) de manière à ce que la première direction (164) du sillon en longueur s'étende suivant le plan qui n'est pas parallèle au un ou aux plusieurs plan(s) préféré(s) de clivage cristallographiques du substrat (100) de base en silicium et n'est pas alignée sur ceux-ci.

8. Procédé suivant l'une quelconque des revendications 1 à 6, dans lequel le substrat de base semi-conducteur comprend un détail (162) indicateur, qui identifie les plans préférés de clivage du substrat (100) de base en silicium, procédé dans lequel en outre :
on met en position le détail (162) indicateur de manière à ce que les plans préférés de clivage du substrat (100) de base en silicium soient antiparallèles et anti-perpendiculaires au détail (162) indicateur, dans lequel le détail (162) indicateur est mis en position de manière à ce que les plans cristallographiques {110}, {011} et {101} du substrat (100) à base de silicium ne soient pas parallèles et ne soient pas perpendiculaires au détail (162) indicateur et ne soient pas alignés sur celui-ci.

9. Procédé suivant la revendication 8, dans lequel le détail (162) indicateur est un bord plat et le procédé comprend en outre former le premier sillon (124) de manière à ce qu'il soit parallèle ou perpendiculaire au bord plat.

10. Procédé suivant l'une quelconque des revendications 1 à 9, dans lequel en outre :
on forme deux premiers sillons (124, 126) s'étendant parallèlement l'un à l'autre suivant une première direction (164) de sillon en longueur, la première direction (164) en longueur étant antiparallèle à l'un ou aux plusieurs plan(s) préféré (s) de clivage cristallographiques du substrat (100) de base en silicium ;
on forme deux deuxièmes sillons s'étendant parallèlement l'un à l'autre suivant une deuxième direction (166) de sillon en longueur, qui est perpendiculaire à la première direction (164) de sillon en longueur et qui n'est pas parallèle au un ou aux plusieurs plan(s) préféré(s) de clivage cristallographiques du substrat (100) de base en silicium et n'est pas alignée sur eux.

11. +Procédé suivant la revendication 10, dans lequel on coupe la couche de semi-conducteur (104) de type III-V et le substrat (100) de base en silicium suivant un premier plan (170) de coupe qui est parallèle à la première direction (164) de signaux en longueur et qui est entre les deux premiers sillons (124, 126).

12. Procédé suivant la revendication 11, dans lequel on forme les deux premiers sillons (124, 126) pour définir des première, deuxième et troisième parties latérales de la couche (104) de type III-V, la première partie latérale étant disposée d'un côté du premier sillon (124), la deuxième partie latérale étant disposée entre le premier et le deuxième sillons (124, 126) et la troisième partie latérale étant disposée d'un côté du deuxième sillon (126) et dans lequel la coupe est formée dans la deuxième partie latérale.

13. Procédé suivant l'une quelconque des revendications 1 à 12, dans lequel en outre :
on remplit le premier sillon (24) d'un matériau (130) de remplissage qui est différent du matériau de la couche (104) de semi-conducteur du type III-V, le matériau de remplissage comprenant l'un quelconque ou une combinaison d'un oxyde semi-conducteur, d'un matériau polycristallin et d'un métal.

14. Procédé suivant l'une quelconque des revendications 1 à 13, dans lequel l'opération d'attaque comprend une technique d'attaque en voie humide, en voie sèche, au plasma ou anisotrope.

15. Puce à semi-conducteur comprenant :
un substrat (100) de base semi-conducteur comprenant une surface (102) plane de croissance ayant une direction cristallographique, le substrat de base semi-conducteur comprenant des plans préférés de clivage cristallographiques, dans laquelle le substrat (100) de base semi-conducteur est une tranche de silicium, la direction cristallographique de la surface (102) plane de croissance est <111> et les plans préférés de clivage sont le {110}, {011} et {101} ;
une couche (104) de semi-conducteur du type III-V formée épitaxialement sur la surface (102) plane de croissance, dans laquelle la couche (104) de semi-conducteur du type III-V comprend une hétérojonction, dans laquelle une région de GaN et une région d'AlGaN, qui ont bandes interdites différentes, sont adjointes l'une à l'autre de manière à former un gaz de porteur à deux dimensions ;
au moins un sillon (124) attaqué, qui est formé dans la couche (104) de semi-conducteur du type III-V et qui s'étend au moins jusqu'à la surface (102) de croissance du substrat (100) de base semi-conducteur ;
dans lequel le au moins un sillon (124) a une direction (164) de sillon en longueur qui n'est pas parallèle aux plans préférés de clivage cristallographiques et qui n'est pas aligné sur eux.

16. Puce à semi-conducteur suivant la revendication 15, dans laquelle la couche (104) de semi-conducteur du type III-V forme un dispositif transistor à base de nitrure du groupe III.
